# EUROPÄISCHE PATENTSCHRIFT

(11) **EP 1 263 161 B1**
(45) Veröffentlichungstag und Bekanntmachung des Hinweises auf die Patenterteilung: **14.12.2005**
(21) Anmeldenummer: 01112093.8
(22) Anmeldetag: 29.05.2001
(51) Int. Cl.: H04L 7/02, G06F 1/12, H03K 5/135

(54) **Synchronisierschaltungsanordnung**
Synchronisation circuit
Circuit de synchronisation

(43) Veröffentlichungstag der Anmeldung: 04.12.2002
(73) Patentinhaber: Infineon Technologies AG, 81669 München (DE)
(72) Erfinder: Buch, Steffen, 81541 München (DE); Gryska, Holger, 81737 München (DE); Simon, Sven, Dr., 28209 Bremen (DE); Müller, Matthias, 76872 Winden (DE)
(74) Vertreter: Banzer, Hans-Jörg

(56) Entgegenhaltungen:
- EP-A- 0 942 533
- WO-A-01/33237
- US-A- 5 987 081
- US-B1- 6 172 540

## Beschreibung

Die vorliegende Erfindung betrifft eine Synchronisierschaltungsanordnung, welche zur Übergabe von Daten zwischen zwei Funktionsblöcken verschiedener Takt-Domänen ohne Datenverlust oder Verdoppelung der Daten aufgrund von Takt-Jitter eingesetzt wird.

In Schaltungen mit verschiedenen Takt-Domänen tritt häufig das Problem auf, dass von einem Funktionsblock bzw. einem Schaltungsabschnitt, welcher mit einem ersten Takt betrieben wird, Daten an einen anderen Funktionsblock bzw. Schaltungsabschnitt, welcher mit einem anderen Takt betrieben wird, übergeben bzw. übertragen werden müssen. Bei sogenannten "Mixed Signal"-Anwendungen kann es sich beispielsweise bei den Funktionsblöcken um einen Analog-Teil und einen Digital-Teil handeln, welche mit unterschiedlichen Takten betrieben werden.

Um bei der Datenübergabe von dem einen Funktionsblock an den anderen Funktionsblock Datenverluste oder Datenverdoppelungen aufgrund von Takt-Jitter weitgehend vermeiden zu können, wird gemäß dem Stand der Technik für beide Funktionsblöcke ein gemeinsamer Referenztakt verwendet, wobei die Betriebstakte für die beiden Funktionsblöcke aus dem gemeinsamen Referenztakt mit zwei separaten Phasenregelkreisen ("Phase Locked Loop", PLL) erzeugt werden. Dabei kommen in den beiden Phasenregelkreisen zur Erzeugung der beiden unterschiedlichen Taktsignale unterschiedliche Frequenzteiler zur Anwendung. Bei dieser herkömmlichen Vorgehensweise müssen jedoch die Phasen- und Laufzeitunterschiede der beiden Taktsignale vor Inbetriebnahme bekannt sein, um durch entsprechende Abstimmung der beiden Funktionsblöcke eine möglichst fehlerfreie Datenübergabe erzielen zu können. Diese herkömmliche Lösung ist daher mit einem sehr hohen Abstimmaufwand vor Inbetriebnahme der Schaltung verbunden.

Zudem kann mit Hilfe dieser herkömmlichen Lösung nicht auf Veränderungen der Laufzeit- bzw. Phasenunterschiede zwischen den beiden Taktsignalen der beiden Funktionsblöcke reagiert werden. Bereits eine leichte Veränderung der Phasenverschiebung der beiden Takte, beispielsweise aufgrund von geringfügigen Temperatur- oder Spannungsschwankungen, kann jedoch zu einer Fehlfunktion bei der Datenübergabe von dem einen Funktionsblock an den anderen Funktionsblock führen. Selbst wenn diese Fehlfunktion hinsichtlich der zugrunde liegenden Signalverarbeitungsfunktionen aufgrund relativ geringer Fehlerhäufigkeiten tolerierbar wären, ist aufgrund einer derartigen Design-Schwäche für den Test der als integrierten Schaltung bzw. als Chip ausgestalteten Schaltungsanordnung mit den gängigen Produktionstestern eine starke Ausbeute-Reduktion zu erwarten. Dies ist unerwünscht.

Aus der US-B1-6,172,540 ist eine Synchronisierschaltungsanordnung nach dem Oberbegriff des unabhängigen Anspruches 1 bekannt. Insbesondere ist aus dieser Druckschrift eine Synchronisierschaltungsanordnung zum Übergeben von Daten von einem ersten Funktionsblock einer ersten Takt-Domäne an einen zweiten Funktionsblock einer zweiten Takt-Domäne bekannt, wobei einem Schaltungsabschnitt ein erstes Taktsignal der ersten Takt-Domäne und ein zweites Taktsignal der zweiten Takt-Domäne zugeführt ist und das zweite Taktsignal eine Taktperiode aufweist, welche einem ganzzahligen Vielfachen der Taktperiode des ersten Taktsignals entspricht. Der erste Schaltungsabschnitt ist derart ausgestaltet, dass er einen zu dem ersten Taktsignal synchronen Impuls erzeugt und an einen zweiten Schaltungsabschnitt ausgibt, wenn ein Takt des zweiten Taktsignals an dem ersten Schaltungsabschnitt anliegt. Der zweite Schaltungsabschnitt empfängt neben den zu dem ersten Taktsignal synchronen Impulsen des ersten Schaltungsabschnitts die zu übertragenden Daten und ist derart ausgestaltet, dass er die Daten periodisch entsprechend den synchronen Impulsen des ersten Schaltungsabschnitts ausgibt.

Aus der WO-A-01/33237 ist ein Verfahren und eine Vorrichtung zum Testen einer Schaltungsanordnung mit zwei oder mehr Takt-Domänen bekannt, wobei eine Synchronisation der von einer Takt-Domäne an eine andere Takt-Domäne übergebenen Signale vorgesehen ist. Zu diesem Zweck kommt eine Teststeuerung zum Einsatz, welche eine Schaltung zur Erzeugung eines Steuersignals und eine Schaltung zur Erzeugung eines lokalen Taktsignals umfasst. Die Schaltung zur Erzeugung des Steuersignals erzeugt ein Freigabesignal für eine Takt-Domäne, wobei diese Schaltung mit dem hochfrequenten Takt der entsprechenden Takt-Domäne betrieben wird. Die Schaltung zur Erzeugung des lokalen Taktsignals erzeugt das hochfrequente Taktsignal der entsprechenden Takt-Domäne.

Der vorliegenden Erfindung liegt daher die Aufgabe zugrunde, eine Synchronisierschaltungsanordnung vorzuschlagen, welche bei einer Datenübergabe zwischen zwei Funktionsblöcken unterschiedlicher Takt-Domänen mit beliebiger Phasenverschiebung zum Einsatz kommen kann, um eine Übergabe der Daten von dem einem Funktionsblock an den anderen Funktionsblock ohne Datenverlust oder Verdoppelung der Daten aufgrund von Takt-Jitter zu ermöglichen.

Diese Aufgabe wird erfindungsgemäß durch eine Synchronisierschaltungsanordnung mit den Merkmalen des Anspruches 1 gelöst. Die Unteransprüche definieren bevorzugte und vorteilhafte Ausführungsformen der vorliegenden Erfindung.

Die erfindungsgemäße Synchronisierschaltungsanordnung umfasst einen ersten Schaltungsabschnitt, dem das (nachfolgend als erstes Taktsignal) bezeichnete Taktsignal des ersten Funktionsblocks und das (nachfolgend als zweites Taktsignal be-zeichnete) Taktsignal des zweiten Funktionsblocks zugeführt wird. Dieser erste Schaltungsabschnitt ist derart ausgestaltet, dass er bei Vorhandensein einen Takt des zweiten Taktsignals einen zu dem ersten Taktsignal synchronen Impuls erzeugt.

Diese Impulse des ersten Schaltungsabschnitts werden in einem zweiten Schaltungsabschnitt verwendet, um eine den Impulsen entsprechende periodische Datenübergabe aus der einen Takt-Domäne in die andere Takt-Domäne zu realisieren.

Der erste Schaltungsabschnitt kann mehrere Register zum Einsynchronisieren des zweiten Taktsignals aufweisen, um somit die Wahrscheinlichkeit für metastabile Zustände zu reduzieren. Am Ausgang dieser Register kann eine Logikschaltung vorgesehen sein, um die zuvor beschriebenen Impulse bei einer steigenden Flanke dieses zweiten Taktsignals zu erzeugen.

Der zweite Schaltungsabschnitt weist an seinem Ausgang ein von einem Zähler angesteuertes Register auf, wobei das Register die von dem einen Funktionsblock an den anderen Funktionsblock zu übergebenden Daten empfängt und ausgangsseitig an diesen anderen Funktionsblock weiterreicht. Das zweite Taktsignal weist gegenüber dem ersten Taktsignal eine ganzzahlig vielfache Taktperiode auf, wobei der Zähler des zweiten Schaltungsabschnitts derart ausgestaltet ist, dass er das erste Taktsignal entsprechend diesem Verhältnis zwischen den Taktperioden der beiden Taktsignale herunterteilt und das Ausgabe- bzw, Übernahmeregister des zweiten Schaltungsabschnitts ansteuert, wobei Übernahmeregister und Ausgaberegister Synonyme sind. Mit dem Zähler kann ein Rückkopplungs-Register gekoppelt sein, wobei der Ausgang dieses Rückkopplungs-Registers mit dem von dem ersten Schaltungsabschnitt gelieferten Impulssignal OR-verknüpft ist, um den Freigabeanschluss des Zählers entsprechend anzusteuern. Auf diese Weise wird gewährleistet, dass das Impulssignal des ersten Schaltungsabschnitts von dem zweiten Schaltungsabschnitt jeweils nur zu Beginn, d.h. bei einem Reset der Schaltung oder bei Vorliegen eines entsprechenden Steuersignals zum Starten eines neuen Aufsynchronisiervorgangs, ausgewertet wird. Aufgrund der speziellen Ausgestaltung des zweiten Schaltungsabschnitts ändern sich die Daten am Ausgang des Ausgabe-oder Übernahmeregisters des zweiten Schaltungsabschnitts zu einem Zeitpunkt, bei dem das Taktsignal der zweiten Takt-Domäne stabil ist. Dadurch wird die Schaltung unempfindlich gegenüber Phasenverschiebungen zwischen den beiden Taktsignalen während des Betriebs der Schaltung, falls diese kleiner als eine Taktperiode sind.

Die vorliegende Erfindung eignet sich allgemein zum Einsatz in allen Schaltungsanordnungen, bei denen Daten zwischen Funktionsblöcken unterschiedlicher Takt-Domänen übertragen werden sollen. Dabei können die Takt-Domänen bzw. Taktsignale der beiden Funktionsblöcke zueinander beliebig phasenverschoben sein. Soll vermieden werden, dass sich während des Betriebs der Schaltung die Phasendifferenz der beiden Taktsignale unbegrenzt, d.h. über mehr als eine Taktperiode, akkumulieren kann, sollten die beiden Taktsignale aus einer gemeinsamen Taktquelle, beispielsweise einem gemeinsamen Phasenregelkreis oder Oszillator, stammen.

Die vorliegende Erfindung wird nachfolgend näher unter Bezugnahme auf die Zeichnung anhand eines bevorzugten Ausführungsbeispiels erläutert.
Figur 1 zeigt den Aufbau einer Synchronisierschaltungsanordnung gemäß einem bevorzugten Ausführungsbeispiel der vorliegenden Erfindung,
Figur 2 zeigt die Verwendung einer erfindungsgemäßen Synchronisierschaltungsanordnung bei der Übergabe von Daten zwischen Funktionsblöcken verschiedener Takt-Domänen, und
Figur 3 zeigt den zeitlichen Verlauf verschiedener in Figur 1 dargestellter Signale während des Betriebs der erfindungsgemäßen Synchronisierschaltungsanordnung.

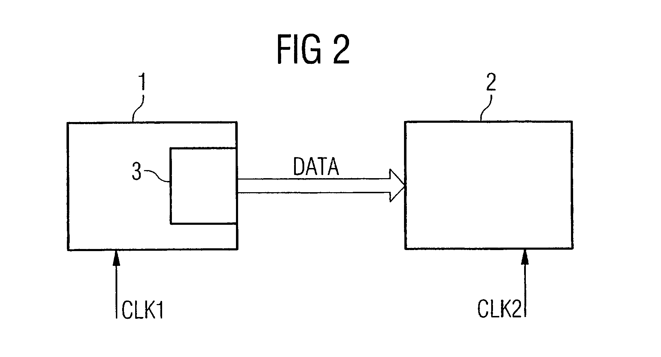

Wie in Figur 2 gezeigt ist, kann die erfindungsgemäße Synchronisierschaltungsanordnung 3 bei der Übergabe von Daten DATA zwischen zwei Funktionsblöcken 1, 2 unterschiedlicher Takt-Domänen mit beliebiger Phasenverschiebung eingesetzt werden, um eine Übergabe der Daten von dem einen Funktionsblock 1 an den anderen Funktionsblock 2 ohne Datenverlust oder Verdoppelung der Daten aufgrund von Takt-Jitter zu ermöglichen. Die Synchronisierschaltungsanordnung 3 kann beispielsweise mit dem Ausgang des ersten Funktionsblocks 1, welcher mit einem ersten Takt CLK1 betrieben wird, gekoppelt sein, um ausgangsseitig die für eine Verarbeitung mit dem zweiten Funktionsblock 2, welcher mit einem zweiten Taktsignal CLK2 betrieben wird, geeigneten Daten DATA bereitzustellen.

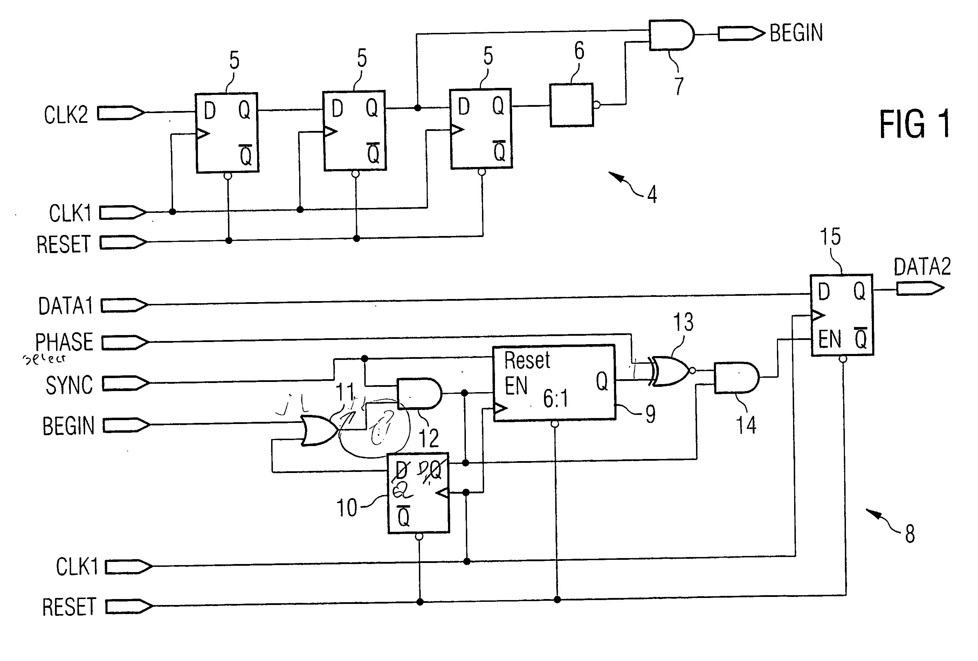

Der Aufbau der Synchronisierschaltungsanordnung soll nachfolgend näher unter Bezugnahme auf Figur 1 erläutert werden. Wie aus Figur 1 ersichtlich ist, umfasst die Synchronisierschaltungsanordnung im Wesentlichen zwei Schaltungsabschnitte 4, 8.

Der erste Schaltungsabschnitt 4 empfängt die beiden Taktsignale CLK1 und CLK2, wobei das Taktsignal CLK2 gegenüber dem Taktsignal CLK1 eine ganzzahlig vielfache Taktperiode besitzt und beliebig phasenverschoben sein kann. Wie in Figur 1 gezeigt ist, umfasst der erste Schaltungsabschnitt 4 eine Schieberegisterkette mit in Form von D-Flipflops ausgebildeten Registern 5, welche mit dem Taktsignal CLK1 getaktet werden, wobei dem ersten Register 5 dieser Schieberegisterkette das Taktsignal CLK2 am Eingang zugeführt ist. Diese Schieberegister 5 werden zur Einsynchronisation des Taktsignals CLK2 verwendet, um somit die Wahrscheinlichkeit für metastabile Zustände zu reduzieren. Das einsynchronisierte Signal erzeugt einen zum Taktsignal CLK1 synchronen Impuls BEGIN bei Vorhandensein einer taksts des Taktsignals CLK2. Dies wird mit Hilfe einer gemäß Figur 1 verschalteten Logikschaltung am Ausgang der Schieberegisterkette erreicht, wobei bei dem dargestellten Ausführungsbeispiel diese Logikschaltung ein NOT-Gatter 6 und ein AND-Gatter 7 umfasst.

Die Register 5 können mit Hilfe eines Reset-Signals RESET zurückgesetzt werden und weisen in diesem Fall dann jeweils den Wert "1" auf.

Der zweite Schaltungsabschnitt 8 verwendet den von dem ersten Schaltungsabschnitt 4 erzeugten Impuls BEGIN, um die periodische Datenübertragung der Daten aus der Takt-Domäne mit dem Taktsignal CLK1 in die Takt-Domäne mit dem Taktsignal CLK2 zu realisieren. Dabei umfasst der zweite Schaltungsabschnitt 8 gemäß Figur 1 ein Übernahmeregister 15, dem die zu übertragenden Daten DATA1 am Eingangsanschluss zugeführt sind. Bei "Mixed Signal"-Anwendungen kann es sich beispielsweise bei dem in Figur 2 gezeigten Funktionsblock 1 um ein Digital-Teil und bei dem Funktionsblock 2 um ein Analog-Teil handeln. Demzufolge können die in Figur 1 dargestellten Daten DATA1 digitale Daten des Funktionsblocks 1 sein.

Aufgrund der speziellen Ausgestaltung des zweiten Schaltungsabschnitts 8 ändern sich die Daten DATA2 am Ausgang des Übernahmeregisters 15 zu einem Zeitpunkt, zu dem das Taktsignal CLK2 stabil ist. Dadurch wird die Schaltung unempfindlich gegenüber Phasenverschiebungen zwischen den beiden Takten CLK1 und CLK2 während des Betriebs der Schaltung, falls diese kleiner als eine Taktperiode sind.

Der zweite Schaltungsabschnitt 8 umfasst einen Zähler 9, der mit dem höherfrequenten Taktsignal CLK1 getaktet wird. Der Zähler 9 dient zum Herunterteilen des Taktsignals CLK1 entsprechend dem Verhältnis zwischen den Taktperioden der beiden Taktsignale CLK1 und CLK2. Weist das Taktsignal CLK2 beispielsweise eine gegenüber dem Taktsignal CLK1 sechsmal höhere Taktperiode auf, ist der Zähler 9 als 6:1-Zähler auszugestalten, so dass der Zähler 9 nach jeweils sechs Takten des Taktsignals CLK1 an seinem Ausgang einen Ausgangsimpuls erzeugt. Über den Ausgang des Zählers 9 wird der Freigabeanschluss EN des Übernahmeregisters 15 angesteuert, um die Ausgabe der Daten DATA2 entsprechend steuern zu können.

Von dem zweiten Schaltungsabschnitt 8 wird das von dem ersten Schaltungsabschnitt 4 erzeugte Impulssignal BEGIN nur zu Beginn der Schaltung ausgewertet, d.h. bei einem Reset mit Hilfe des in Figur 1 dargestellten Reset-Signals RESET oder bei Vorliegen eines Synchronisierimpulses eines ebenfalls in Figur 1 gezeigten Signals SYNC, mit dessen Hilfe jeweils eine neue Aufsynchronisation der Synchronisierschaltungsanordnung gestartet werden kann. Zu diesem Zweck ist gemäß Figur 1 ein Rückkopplungs-Register 10 vorgesehen, welches mit dem Taktsignal CLK1 getaktet und wie in Figur 1 gezeigt verschaltet ist. Der Eingang des Rückkopplungs-Registers 10 ist mit dem Freigabeanschluss EN des Zählers 9 verbunden, während der Ausgang des Rückkopplungs-Registers 10 über ein OR-Gatter 11 mit dem Impulssignal BEGIN verknüpft wird. Der Ausgang des OR-Gatters 11 ist zusammen mit dem bereits zuvor erwähnten Signal SYNC einem AND-Gatter 12 zugeführt, dessen Ausgang den Freigabeanschluss EN des Zählers 9 ansteuert. Das Signal SYNC ist darüber hinaus an einen Reset-Eingang des Zählers 9 geführt, so dass der Zähler 9 einerseits durch das Signal SYNC und andererseits durch das Signal RESET zurückgesetzt werden kann.

Wie in Figur 1 gezeigt ist, ist der Ausgang des Zählers 9 nicht direkt mit dem Freigabeanschluss des Übernahmeregisters 15 verbunden. Vielmehr ist eine Logikschaltung zwischengeschaltet, welche ermöglicht, dass mit Hilfe eines Phasensignals PHASE ausgewählt werden kann, welcher Zählerstand des Zählers 9 zur Erzeugung eines Freigabeimpulses für das Übernahmeregister 15 verwendet werden soll. Bei dem dargestellten Ausführungsbeispiel umfasst die Logikschaltung ein XNOR-Gatter 13, welches als Eingangssignale das Phasensignal PHASE und das Ausgangssignal des Zählers 9 empfängt, sowie ein AND-Gatter 14, welches eingangsseitig mit dem Ausgang des XNOR-Gatters 13 und dem Eingang des Rückkopplungs-Registers 10 verbunden ist, wobei der Ausgang des AND-Gatters 14 den Freigabeanschluss des Übernahmeregisters 15 ansteuert.

Wie bereits zuvor erwähnt worden ist, kann mit Hilfe des Signals SYNC jeweils ein neuer Aufsynchronisationsvorgang gestartet werden. Stammen die beiden Taktsignale CLK1 und CLK2 nicht von einer gemeinsam Taktquelle und soll eine beliebige Akkumulation der Phasendifferenz der beiden Taktsignale CLK1 und CLK2 über mehr als eine Taktperiode vermieden werden, muss entsprechend häufiger ein Impuls des Signals SYNC erzeugt werden, um entsprechend häufiger einen neuen Aufsynchronisationsvorgang zum Nachregeln der Datenübergabe zu starten.

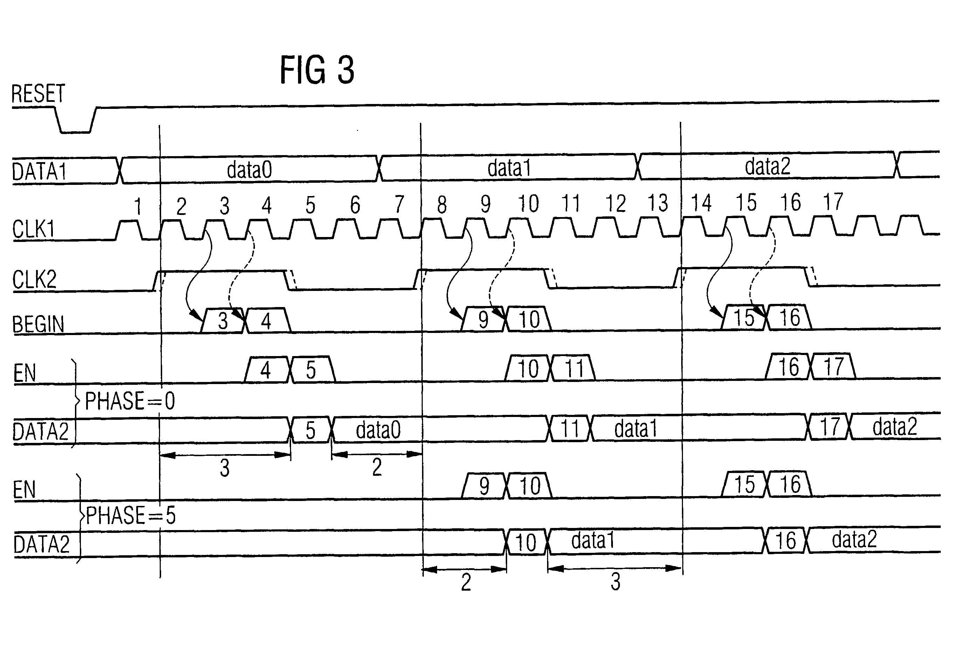

In Figur 3 ist beispielhaft der Verlauf der zuvor erläuterten Signale bei dem in Figur 1 gezeigten Ausführungsbeispiel dargestellt, wobei beispielhaft davon ausgegangen worden ist, dass das zweite Taktsignal CLK2 eine sechsmal höhere Taktperiode als das erste Taktsignal CLK1 aufweist. Die einzelnen Datenblöcke bzw. Datenpakete der zu übertragenden Daten DATA1 sind gemäß Figur 3 mit data0 ... data2 bezeichnet. Darüber hinaus sind in Figur 3 die einzelnen Takte des Taktsignals CLK1 nacheinander mit 1 ... 17 numeriert. Hinsichtlich der weiteren in Figur 3 dargestellten Signale BEGIN, EN und DATA2 ist jeweils durch entsprechende Nummerierung angegeben, auf welchen Taktimpuls des Taktsignals CLK1 der entsprechende Impuls dieser Signale zurückgeht.

In Figur 3 ist der Verlauf des Freigabesignals EN des Zählers 9 sowie entsprechend die von dem Übernahmeregister 15 ausgegebenen Daten DATA2 für zwei unterschiedliche Belegungen des Phasensignals PHASE dargestellt. Im ersten dargestellten Fall wird mit Hilfe des Phasensignals PHASE festgelegt, dass immer durch das XNOR-Gatter 13 bei einem Zählerstand von "0" an den Freigabeanschluss des Übernahmeregisters 15 angelegt wird (d.h. PHASE=0). Im zweiten dargestellten Fall wird durch das Phasensignal PHASE festgelegt, dass durch das XNOR-Gatter 13 immer bei einem Zählerstand von "5" ein Impuls für das Übernahmeregister 15 ausgegeben wird (d.h. PHASE=5).

Aus Figur 3 ist ersichtlich, wie die Eingangsdaten DATA1 in Form der Daten DATA2 in Übereinstimmung mit den Impulsen des Impulssignals BEGIN periodisch weitergereicht werden.

## Patentansprüche

1. Synchronisierschaltungsanordnung zum Übergeben von Daten von einem ersten Funktionsblock (1) einer ersten Takt-Domäne an einen zweiten Funktionsblock (2) einer zweiten Takt-Domäne,
mit einem ersten Schaltungsabschnitt (4), welcher ein erstes Taktsignal (CLK1) der ersten Takt-Domäne und ein zweites Taktsignal (CLK2) der zweiten Takt-Domäne empfängt und derart ausgestaltet ist, dass er einen zu dem ersten Taktsignal (CLK1) synchronen Impuls (BEGIN) erzeugt, wenn ein Takt des zweiten Taktsignals (CLK2) anliegt, und
mit einem zweiten Schaltungsabschnitt (8), welcher die Daten (DATA1) und die von dem ersten Schaltungsabschnitt (4) erzeugten synchronen Impulse (BEGIN) empfängt und derart ausgestaltet ist, dass er die Daten (DATA1) periodisch entsprechend den synchronen Impulsen (BEGIN) des ersten Schaltungsabschnitts (4) ausgibt,
**dadurch gekennzeichnet,**
**dass** der zweite.Schaltungsabschnitt (8) einen mit dem ersten Taktsignal (CLK1) getakteten Zähler (9) zum Herunterteilen des ersten Taktsignals (CLK1) entsprechend dem ganzzuhligen Vielfachen Verhältnis zwischen der Taktperiode des zweiten Taktsignals (CLK2) und der Taktperiode des ersten Taktsignals (CLK1) umfasst, wobei der Zähler (9) einen Freigabeimpuls für ein Ausgaberegister (15), an dem die zu übergebenden Daten (DATA1) anliegen, erzeugt.

2. Synchronisierschaltungsanordnung nach Anspruch 1,
**dadurch gekennzeichnet,**
**dass** der erste Schaltungsabschnitt (4) eine Schieberegisterkette (5) umfasst, wobei der Schieberegisterkette (5) als Eingangssignal das zweite Taktsignal (CLK2) zugeführt ist und die Schieberegisterkette (5) mit dem ersten Taktsignal (CLK1) getaktet ist.

3. Synchronisierschaltungsanordnung nach Anspruch 2,
**dadurch gekennzeinehnet,**
dass der Ausgang der Schieberegisterkette (5) mit einer Logikschaltung (6, 7) zur Erzeugung der synchronen Impulse (BEGIN), wenn ein Takt des zweiten Taktsignals (CLK2) anliegt, synchron zu dem ersten Taktsignal (CLK1) gekoppelt ist.

4. Synchronisierschaltungsanordnung nach Anspruch 3,
**dadurch gekennzeichnet,**
**dass** die Logikschaltung ein logisches NOT-Gatter (6), dessen Eingang mit dem Ausgang der Schieberegisterkette (5) verbunden ist, und ein logisches AND-Gatter (7), welches mit einem Eingang mit dem Ausgang des NOT-Gatters (6) und mit einem anderen Eingang mit dem Dateneingang des letzten Schieberegisters (5) der Schieberegisterkette verbunden ist, umfasst, wobei am Ausgang des AND-Gatters (7) die Impulse (BEGIN) abgreifbar sind.

5. Synchronisierschaltungsanordnung nach einem der vorhergehenden Ansprüche,
**dadurch gekennzeichnet,**
**dass** der zweite Schaltungsabschnitt (8) ein mit dem ersten Taktsignal (CLK1) getaktetes Rückkopplungs-Register (10) und ein logisches OR-Gatter (11) umfasst,
wobei der Dateneingang des Rückkopplungs-Registers (10) mit einem Freigabeanschluss des Zählers (9) verbunden ist, und
wobei an einen Eingang des OR-Gatters (11) die von dem ersten Schaltungsabschnitt (4) erzeugten Impulse (BEGIN) geführt sind, während ein anderer Eingang des OR-Gatters (11) mit dem Datenausgang des Rückkopplungs-Registers (10) verbunden ist,
wobei der Ausgang des OR-Gatters (11) mit dem Freigabeanschluss des Zählers (9) gekoppelt ist.

6. Synchronisierschaltungsanordnung nach Anspruch 5,
**dadurch gekennzeichnet,**
**dass** der zweite Schaltungsabschnitt (8) ein logisches AND-Gatter (12) umfasst, wobei ein Eingang des AND-Gatters (12) mit dem Ausgang des OR-Gatters (11) verbunden ist, während ein anderer Eingang des AND-Gatters (12) ein Synchronisierstartsignal (SYNC) empfängt, und wobei der Ausgang des AND-Gatters (12) mit dem Freigabeanschluss des Zählers (9) verbunden ist.

7. Synchronisierschaltungsanordnung nach Anspruch 6,
**dadurch gekennzeichnet,**
**dass** der Zähler (9) einen mit dem Synchronisierstartsignal (SYNC) verbundenen Reset-Eingang aufweist.

8. Synchronisierschaltungsanordnung nach einem der vorhergehenden Ansprüche,
**dadurch gekennzeichnet,**
**dass** der zweite Schaltungsabschnitt (8) eine zwischen den Ausgang des Zählers (9) und den Freigabeanschluss des Ausgaberegisters (15) geschaltete Logikschaltung (13, 14) umfasst,
wobei die Logikschaltung (13, 14) derart ausgestaltet ist, dass in Abhängigkeit von einem der Logikschaltung (13, 14) zugeführten Steuersignal (PHASE) ein Freigabeimpuls für den Freigabeanschluss des Ausgaberegisters (15) bei einem bestimmen Zählerstand des Zählers (9) erzeugt wird.

9. Synchronisierschaltungsanordnung nach Anspruch 8,
**dadurch gekennzeichnet,**
**dass** die Logikschaltung des zweiten Schaltungsabschnitts (8) ein logisches XNOR-Gatter (13) und ein logisches AND-Gatter (14) umfasst,
wobei ein Eingang des XNOR-Gatters (13) das Steuersignal (PHASE) empfängt und ein anderer Eingang des XNOR-Gatters (13) mit dem Ausgang des Zählers (9) verbunden ist, und
wobei ein Eingang des AND-Gatters (14) mit dem Ausgang des XNOR-Gatters (13) und ein anderer Eingang des AND-Gatters (14) mit dem Freigabeanschluss des Zählers (9) verbunden ist, während der Ausgang des AND-Gatters (14) mit dem Freigabeanschluss des Ausgaberegisters (15) verbunden ist.

## Claims

1. Synchronization circuit arrangement for transferring data from a first function block (1) of a first clock domain to a second function block (2) of a second clock domain,
having a first circuit section (4), which receives a first clock signal (CLK1) of the first clock domain and a second clock signal (CLK2) of the second clock domain and is configured in such a way that it generates a pulse (BEGIN) synchronous with the first clock signal (CLK1) if a clock of the second clock signal (CLK2) is present, and
having a second circuit section (8), which receives the data (DATA1) and the synchronous pulses (BEGIN) generated by the first circuit section (4) and is configured in such a way that it outputs the data (DATA1) periodically in accordance with the synchronous pulses (BEGIN) of the first circuit section (4),
**characterized**
**in that** the second circuit section (8) comprises a counter (9) clocked with the first clock signal (CLK1) and serving for dividing down the first clock signal (CLK1) in accordance with the integral multiple ratio between the clock period of the second clock signal (CLK2) and the clock period of the first clock signal (CLK1), the counter (9) generating an enable pulse for an output register (15), at which the data (DATA1) to be transferred are present.

2. Synchronization circuit arrangement according to Claim 1,
**characterized**
**in that** the first circuit section (4) comprises a shift register chain (5), the second clock signal (CLK2) being fed to the shift register chain (5) as input signal and the shift register chain (5) being clocked with the first clock signal (CLK1).

3. Synchronization circuit arrangement according to Claim 2,
**characterized**
**in that** the output of the shift register chain (5) is coupled to a logic circuit (6, 7) for generating the synchronous pulses (BEGIN), if a clock of the second clock signal (CLK2) is present, synchronously with the first clock signal (CLK1).

4. Synchronization circuit arrangement according to Claim 3,
**characterized**
**in that** the logic circuit comprises a logic NOT gate (6), the input of which is connected to the output of the shift register chain (5), and a logic AND gate (7), which is connected by one input to the output of the NOT gate (6) and by another input to the data input of the last shift register (5) of the shift register chain, it being possible for the pulses (BEGIN) to be tapped off at the output of the AND gate (7).

5. Synchronization circuit arrangement according to one of the preceding claims,
**characterized**
**in that** the second circuit section (8) comprises a feedback register (10) clocked with the first clock signal (CLK1) and a logic OR gate (11),
the data input of the feedback register (10) being connected to an enable terminal of the counter (9), and the pulses (BEGIN) generated by the first circuit section (4) being passed to one input of the OR gate (11), while another input of the OR gate (11) is connected to the data output of the feedback register (10), the output of the OR gate (11) being coupled to the enable terminal of the counter (9).

6. Synchronization circuit arrangement according to Claim 5,
**characterized**
**in that** the second circuit section (8) comprises a logic AND gate (12), one input of the AND gate (12) being connected to the output of the OR gate (11), while another input of the AND gate (12) receives a synchronization start signal (SYNC), and the output of the AND gate (12) being connected to the enable terminal of the counter (9).

7. Synchronization circuit arrangement according to Claim 6,
**characterized**
**in that** the counter (9) has a reset input connected to the synchronization start signal (SYNC).

8. Synchronization circuit arrangement according to one of the preceding claims,
**characterized**
**in that** the second circuit section (8) comprises a logic circuit (13, 14) connected between the output of the counter (9) and the enable terminal of the output register (15), the logic circuit (13, 14) being configured in such a way that, in a manner dependent on a control signal (PHASE) fed to the logic circuit (13, 14), an enable pulse is generated for the enable terminal of the output register (15) in the event of a specific counter reading of the counter (9).

9. Synchronization circuit arrangement according to Claim 8,
**characterized**
**in that** the logic circuit of the second circuit section (8) comprises a logic XNOR gate (13) and a logic AND gate (14),
one input of the XNOR gate (13) receiving the control signal (PHASE) and another input of the XNOR gate (13) being connected to the output of the counter (9), and
one input of the AND gate (14) being connected to the output of the XNOR gate (13) and another input of the AND gate (14) being connected to the enable terminal of the counter (9), while the output of the AND gate (14) is connected to the enable terminal of the output register (15).

## Revendications

1. Circuit de synchronisation pour la transmission de données d'un premier bloc fonctionnel (1) d'un premier domaine d'horloge vers un second bloc fonctionnel (2) d'un second domaine d'horloge, comprenant
- un premier segment de circuit (4), qui reçoit un premier signal d'horloge (CLK1) du premier domaine d'horloge et un second signal d'horloge (CLK2) du second domaine d'horloge et qui est conçu de façon telle qu'il génère une impulsion (BEGIN) synchrone par rapport au premier signal d'horloge (CLK1) lorsqu'une impulsion d'horloge du second signal d'horloge (CLK2) se présente, et
- un second segment de circuit (8) qui reçoit les données (DATA1) et les impulsions (BEGIN) synchrones générées par le premier segment de circuit (4), et qui est conçu de façon telle qu'il délivre les données (DATA1) périodiquement en sortie, en fonction des impulsions (BEGIN) synchrones du premier segment de circuit (4),
**caractérisé en ce que** le second segment de circuit (8) comprend un compteur (9) qui est cadencé avec le premier signal d'horloge (CLK1) pour abaisser le premier signal d'horloge (CLK1) en fonction du rapport entre la période d'horloge multiple d'un nombre entier du second signal d'horloge (CLK2) et la période d'horloge du premier signal d'horloge (CLK1), le compteur (9) générant ce faisant une impulsion de validation pour un registre de transfert (15) auquel se présentent les données à transmettre (DATA1).

2. Circuit de synchronisation selon la revendication 1, **caractérisé en ce que** le premier segment de circuit (4) comprend une chaîne de registre à décalage (5), à laquelle est amené en tant que signal d'entrée le second signal d'horloge (CLK2), la chaîne de registre à décalage (5) étant cadencée avec le premier signal d'horloge (CLK1).

3. Circuit de synchronisation selon la revendication 2, **caractérisé en ce que** la sortie de la chaîne de registre à décalage (5) est couplée de façon synchrone par rapport au premier signal d'horloge (CLK1) à un circuit logique (6, 7) pour générer les impulsions (BEGIN) synchrones lorsque se présente une impulsion du second signal d'horloge (CLK2).

4. Circuit de synchronisation selon la revendication 3, **caractérisé en ce que** le circuit logique comprend une porte logique NOT (6) dont l'entrée est reliée à la sortie de la chaîne de registre à décalage (5), et une porte logique AND (7), qui est reliée au niveau d'une entrée à la sortie de la porte logique NOT (6) et au niveau d'une autre entrée à l'entrée de données du dernier registre à décalage (5) de la chaîne de registre à décalage, les impulsions (BEGIN) pouvant être captées en sortie de la porte logique AND (7).

5. Circuit de synchronisation selon l'une quelconque des revendications précédentes, **caractérisé en ce que** le second segment de circuit (8) comprend un registre de retour (10) qui est cadencé avec le premier signal d'horloge (CLK1) et une porte logique OR (11), l'entrée des données du registre de retour (10) étant reliée à une connexion de validation du compteur (9), les impulsions (BEGIN) générées par le premier segment de circuit (4) étant amenées à une entrée de la porte logique OR (11), tandis qu'une autre entrée de la porte logique OR (11) est reliée à la sortie de données du registre de retour (10), la sortie de la porte logique OR (11) étant ce faisant couplée à la connexion de validation du compteur (9).

6. Circuit de synchronisation selon la revendication 5, **caractérisé en ce que** le second segment de circuit (8) comprend une porte logique AND (12), une entrée de la porte logique AND (12) étant reliée à la sortie de la porte logique OR (11), tandis qu'une autre entrée de la porte logique AND (12) reçoit un signal de départ de synchronisation (SYN), la sortie de la porte logique AND (12) étant reliée à la connexion de validation du compteur (9).

7. Circuit de synchronisation selon la revendication 6, **caractérisé en ce que** le compteur (9) comprend une entrée de réinitialisation reliée au signal de départ de synchronisation (SYN).

8. Circuit de synchronisation selon l'une quelconque des revendications précédentes, **caractérisé en ce que** le second segment de circuit (8) comprend un circuit logique (13, 14) intercalé entre la sortie du compteur (9) et la connexion de validation du registre de transfert (15), le circuit logique (13, 14) étant conçu de façon telle qu'en fonction d'un signal de commande (PHASE) amené au circuit logique (13, 14) une impulsion de validation pour la connexion de validation du registre de transfert (15) est générée lorsque le compteur (9) présente une indication de compteur prédéterminée.

9. Circuit de synchronisation selon la revendication 8, **caractérisé en ce que** le circuit logique du second segment de circuit (8) comprend une porte logique XNOR (13) et une porte logique AND (14), une entrée de la porte logique XNOR (13) recevant le signal de commande (PHASE) et une autre entrée de la porte logique XNOR (13) étant reliée à la sortie du compteur (9), et une autre entrée de la porte logique AND (14) étant reliée à la connexion de validation du compteur (9), tandis que la sortie de la porte logique AND (14) est reliée à la connexion de validation du registre de transfert (15).
